# EUROPEAN PATENT SPECIFICATION

(11) **EP 3 009 810 B1**
(45) Date of publication and mention of the grant of the patent: **19.06.2019**
(21) Application number: 14189045.9
(22) Date of filing: 15.10.2014
(51) Int. Cl.: G01D 11/24, G08B 13/00, F16M 13/02, G08B 13/19, H05K 5/02

(54) **A device comprising a first element, a second element and a locking device for fastening the first element to the second element and a method for assembling such a device**
Vorrichtung mit einem ersten Element, einem zweiten Element und einer Verriegelungsvorrichtung zur Befestigung des ersten Elements an das zweite Element und Verfahren zur Montage solch einer Vorrichtung
Dispositif comprenant un premier élément, un second élément et un dispositif de verrouillage pour fixer le premier élément au second élément et procédé d'assemblage d'un tel dispositif

(43) Date of publication of application: 20.04.2016
(73) Proprietor: Verisure Sàrl, 1290 Versoix (CH)
(72) Inventor: Mårtensson, Henrik, 223 58 Lund (SE)
(74) Representative: Hansson Thyresson AB

(56) References cited:
- DE-U1-202005 016 936
- JP-A- 2013 046 011
- US-A- 4 053 777
- US-A- 4 603 829
- US-A1- 2012 150 487

## Description

### TECHNICAL FIELD

The invention relates to a device comprising a first element, a second element, a third element and a locking device for fastening the first element to the second element. The invention also relates to a method for assembling said device. The locking device is connected to the first element and is arranged for locking engagement with the second element by rotation. Such devices can be used for a variety of products and for a variety of purposes. One example is a casing and bracket comprising the first element in the form of a casing or casing front cover and the second element in the form of the bracket, such as a wall bracket or similar, wherein the locking device connects the casing or front cover to the bracket.

The device according to the present invention can be used for a casing and bracket to an intrusion alarm system component, such as an intrusion alarm detector or an intrusion alarm gateway. Such alarm system components are often mounted on a structure, such as a wall, a door, a window frame, etc., wherein a cover structure or a casing is mounted on a bracket. Such alarm systems are commonly used in domestic houses and office premises as well as other buildings as alarm systems to detect unauthorised intrusion such as burglary, damages and similar.

### PRIOR ART

A variety of devices comprising a first element, a second element and a locking device for fastening the first element to the second element to each other are known in the prior art. One type of such prior art devices comprises a rotatable locking device for fastening the first element to the second element, wherein the locking device can be rotated from an open position to a locking position. US4603829 discloses a system for fixing a case onto a body, wherein the case is placed on a mounting base secured to the body by fitting projections into holes on the base and then displacing the case with the aid of a key to fix the case to the base.

One problem with such prior art devices for fastening a first element to a second element is that they are complicated and comprise a plurality of parts.

Another problem with such prior art devices is that the assembly thereof is difficult, time consuming and expensive.

Another problem with such prior art devices is that they can be difficult to manufacture.

Another problem with such prior art devices is that they can be unwieldy, resulting in unnecessary large or undesired structure dimensions.

Another problem with such prior art devices is that it can be difficult to fasten the first element to the second element by means of the locking device.

### SUMMARY OF THE INVENTION

An object of the present invention is to avoid the problems of the prior art. The device and method according to the invention result in a simple and compact structure having few parts, which are easy to assemble. Further, the present invention makes it possible to form all parts, such as a first element, a second element, a locking device and a third element, of plastic materials. Hence, no metal is needed but can be used wholly or partially for appearance purposes. Further, the invention results in fastening of the first element to the second element by rotation of the locking device less than one turn, such as less than 180 degrees or for example about 90 degrees. Hence, instead of screwing a conventional screw a plurality of turns as with prior art devices the invention results in time efficient and easy fastening of the first element to the second element, particularly when the space for using a screw driver is limited.

The present invention relates to a device comprising a first element, a second element, a third element and a locking device for fastening the first element to the second element, wherein the third element is fixed to the first element, and wherein the locking device is connected to the first element and is rotatable around an axis of rotation from an open position to a locked position to engage the second element, characterised in that the locking device comprises a cylinder portion extending along the axis of rotation, a flange extending radially from a first end of the cylinder portion, and an axially extending protrusion connected to a second end of the cylinder portion, the first element is provided with a through aperture for receiving the cylinder portion of the locking device, wherein the flange of the locking device engages a first side of the first element at the aperture, the second element is provided with a projection for interaction with the protrusion of the locking device, the locking device comprises a radial extension extending around a part of the circumference of the cylinder portion, the aperture is formed with a notch for receiving the radial extension, and the third element is provided with a stop to prevent the locking device from rotating to a position in which the extension is aligned with the notch. The arrangement of the elements and the locking device results in a simple and effective locking between two elements, such as for locking a casing on a bracket or similar. Hence, an operator can lock the two elements together in a fast and easy way, for example by means of a simple tool, so that locking can be performed also at a bottom side of the device and also close to a floor or other structure that otherwise may be in the way. Hence, the invention results in easy on-site locking of, for example, an alarm system gateway or an alarm system detector to a wall bracket or similar. Further, the device according to the invention is simple to manufacture and assemble, which results in a cost efficient production and assembly. For example, all components of the device can be manufactured in plastic materials.

The projection of the second element can extend axially and can be arranged between the protrusion and the axis of rotation to engage the protrusion when the locking device is in its locked position. Hence, the protrusion can be positioned behind the projection to prevent the protrusion from radial movement to provide efficient locking. For example the protrusion is positioned in a groove behind the projection for locking in both radial and axial directions except for in one rotational direction to unlock the locking device.

The protrusion is displaced radially from the axis of rotation. The locking device can, for example, comprise a radially extending arm with the protrusion.

The protrusion and the extension can be positioned substantially diametrically on the cylinder portion. Hence, the protrusion and the extension are inserted through the aperture and the locking device cannot be removed from the first element when the extension is rotated away from the notch, which results in easy and efficient assembly of the locking device.

The aperture can, except from the notch, be circular or formed with equivalent shape, so that the cylinder portion of the locking device can be rotated in the aperture. Hence, the locking device can be easily fitted in the aperture and rotated therein while being effectively attached to the first element.

The stop can be arranged to engage the protrusion in the locked position of the locking device and prevent the locking device from further rotation in the same direction. Hence, the stop can prevent the locking device from rotating back to a position in which the extension is aligned with the notch, wherein undesired disassembly of the device is prevented.

The first element can be provided with a rib for interaction with the locking device to prevent undesired rotation thereof, for example to form a stop in the fully open position. The first element can comprise one or more pins and or one or more bumps or indentations for interaction with the locking device, such as a corresponding crest, bump or indentation of the locking device, to detachably fasten the locking device in the closed and open positions and/or to form a tactile indication that the locking device has reached the open or locked position.

The device can be a casing and a bracket, wherein the bracket is arranged for mounting on a structure, such as a wall, ceiling, door frame, door, window frame or any other structure, for example by conventional fastening means such as screws. The casing can be arranged for mounting on the bracket by means of the locking device. The first element can be a casing front cover, the second element can be the bracket and the third element can be a casing back cover, an inner frame or similar. The casing can be arranged for enclosing electronic parts, such as an intrusion alarm component, for example an alarm gateway, an intrusion detector or similar. Hence, efficient and reliable mounting of an intrusion alarm component on a bracket is achieved.

The invention also relates to a method for assembling a device comprising a first element, a second element, a third element and a locking device for fastening the first element to the second element, comprising the steps of
a) inserting a locking device into a through aperture in the first element,
b) aligning a radial extension of the locking device with a notch of the aperture in the first element,
c) pushing the extension through the notch and an axially extending cylinder portion of the locking device into the aperture until a radially extending flange of the locking device engages a first side of the first element around the aperture,
d) rotating the locking device so that the extension is displaced in relation to the notch,
e) fixing a third element to the first element, the third element preventing the locking device from rotating to a position in which the extension is aligned with the notch,
f) bringing the second element into engagement with the first element, and
g) rotating the locking device and thereby bring an axially extending protrusion of the locking device into locking engagement with a projection of the second element.

The method can be a method for assembling an intrusion alarm casing and mounting said casing on a bracket.

Further characteristics and advantages of the present invention will become apparent from the description of the embodiments below, the appended drawings and the dependent claims.

### BRIEF DESCRIPTION OF THE DRAWINGS

In order that the manner in which the above recited and other advantages and objects of the invention are obtained will be readily understood, a more particular description of the invention briefly described above will be rendered by reference to specific embodiments thereof which are illustrated in the appended drawings.

Understanding that these drawings depict only typical embodiments of the invention and are not therefore to be considered to be limiting of its scope, the invention will be described and explained with additional specificity and detail through the use of the accompanying drawings in which:
- Fig. 1: is a schematic perspective view of a device comprising a first element, a second element and a locking device for fastening the first element to the second element according to one embodiment of the invention,
- Fig. 2: is a schematic view of a part of the device of Fig. 1, showing a first side of the locking device,
- Fig. 3: is a schematic section view of the locking device according to one embodiment of the invention,
- Fig. 4: is a schematic view of a second side of the locking device of Fig. 3,
- Fig. 5: is a schematic cross section view of a part of the first element according to one embodiment of the invention, showing an aperture with a notch for receiving the locking device,
- Fig. 6: is a schematic section view of a part of the first element and the locking device according to one embodiment of the invention, wherein the locking device is inserted into the aperture through the notch,
- Fig. 7: is a schematic section view according to Fig. 6, wherein the locking device has been rotated in the aperture so that an extension of the locking device is displaced in relation to the notch,
- Fig. 8: is a schematic cross section view, wherein a third element is fixed to the first element,
- Fig. 9: is a schematic longitudinal section view of a part of the first element, the locking device and the third element according to Fig, 8,
- Fig. 10: is a schematic cross section view of a part of the first element, the locking device and the third element, wherein the locking device is in its open position,
- Fig. 11: is a schematic cross section view of a part of the device according to one embodiment, wherein the assembly of Fig. 10 is fitted to the second element and the locking device is in its open position,
- Fig. 12: is a schematic longitudinal section view according to Fig. 11, wherein the locking device is in its locked position,
- Fig. 13: is a schematic cross section view of a part of the device according to one embodiment, wherein the second element is fastened to a structure by fastening means and the locking device is in its locked position,
- Fig. 14: is a schematic cross section view of the device according to Fig. 13, wherein the locking device is in its open position,
- Fig. 15: is a schematic longitudinal section view of the device according to Fig. 12,
- Fig. 16: is a schematic perspective view of the device according to an alternative embodiment,
- Fig. 17: is a schematic perspective view of the first element and the locking according to one embodiment,
- Fig. 18: is a schematic perspective view of the third element according to one embodiment,
- Fig. 19: is a schematic perspective view of the second element according to one embodiment,
- Fig. 20: is a schematic perspective view of the locking device,
- Fig. 21: is a schematic cross section view of the device of Figs. 19-21, showing the locking device in a locked position,
- Fig. 22: is a schematic longitudinal section view of the device of Fig. 21,
- Fig. 23: is a schematic cross section view of the device of Fig. 21, showing the locking device in an open position, and
- Fig. 24: is a schematic longitudinal section view of the device of Fig. 23,

### DETAILED DESCRIPTION

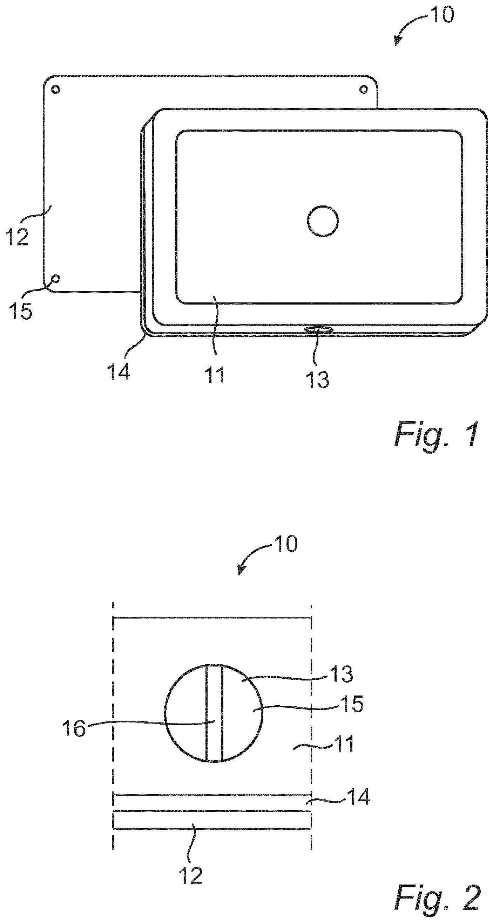

With reference to Fig. 1 a device 10 according to one embodiment of the invention is illustrated. The device 10 comprises a first element 11, a second element 12 and a locking device 13. The locking device 13 is arranged for fastening the first element 11 to the second element 12. The device 10 also comprises a third element 14. For example, the first element 11 is a casing or a casing front cover, wherein the second element 12 is a bracket for mounting on a structure, such as a wall, ceiling, door frame, window frame or any other suitable supporting structure. For example, the second element 12 is fastened to the supporting structure by means of conventional fastening means 15, such as screws or similar, wherein the first element 11 can be attached to the second element 12 by means of the locking device 13. For example, the third element 14 is a back cover, wherein the first element 11 and the third element 14 form the casing for mounting on the second element 12. According to one embodiment, the first element 11 and the third element 14 form a box-shaped enclosure. For example, the device 10 is an intrusion alarm component, wherein the first element 11 is a casing or cover containing electronic parts, a detector, an intrusion alarm gateway or similar, and wherein the first element 11 is arranged for mounting on the second element 12 in the form of a bracket. In the embodiment of Fig. 1 the device 10 is, for example, an intrusion alarm gateway or a casing and bracket for an intrusion alarm gateway. Alternatively, the first element 11 and the second element 12 are any suitable type of structures for attachment to each other by means of the locking device 13. The device 10 is, for example, made of plastic materials. For example, the device 10 is exclusively made of plastic materials. In the illustrated embodiment, the locking device 13 is arranged in a bottom side of the first element 11, such as in a horizontal lower wall thereof extending perpendicular to the second element 12.

With reference to Fig. 2 a part of the device 10 is illustrated, wherein an exterior side of the locking device 13 is illustrated more in detail according to one embodiment. The locking device 13 is arranged in a wall part of the first element 11, wherein an exterior face of the locking device 13, for example, extends in a plane of said wall. In the illustrated embodiment, the locking device 13 comprises a groove 16 for receiving a tool, such as a screwdriver, the peripheral part of a coin or any other suitable tool for rotating the locking device 13. The groove 16 extends across the exterior face of the locking device 13.

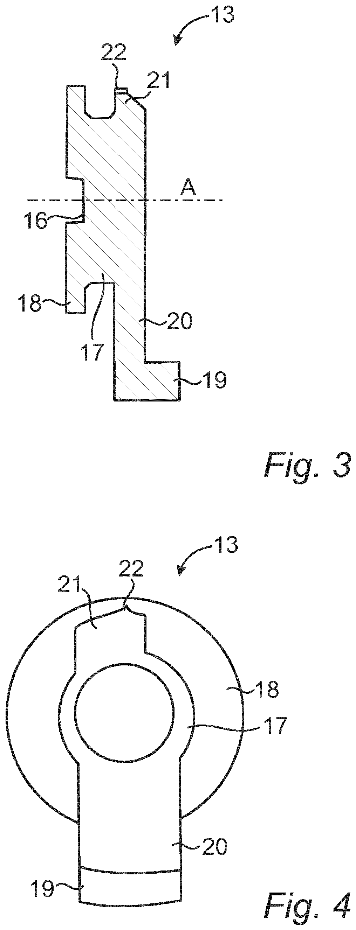

With reference to Figs. 3 and 4 the locking device 13 is illustrated according to one embodiment. The locking device 13 comprises an axis of rotation A, a cylinder portion 17, a flange 18 and a protrusion 19. The cylinder portion 17 extends along the axis of rotation A and is arranged between the flange 18 and the protrusion 19. The flange 18 extends radially from a first end of the cylinder portion 17, wherein the protrusion 19 extends axially from a second end of the cylinder portion 17. For example, the flange 18 extends around the entire periphery of the first end of the cylinder portion 17. Alternatively, the flange 18 is interrupted by cuts forming tabs or similar distributed around the periphery of the first end of the cylinder portion 17. For example, the cylinder portion 17 is formed with a circular cross section or a substantially circular cross section to be able to be rotated in an aperture, which is described more in detail below. In the embodiment of Figs. 3 and 4 the protrusion 19 is arranged on an arm 20 extending radially from the cylinder portion 17, such as from the second end of the cylinder portion 17. The locking device 13 also comprises a radial extension 21. The radial extension 21 is connected to the second end of the cylinder portion 17, wherein the cylinder portion 17 is arranged between the radial extension 21 and the flange 18. Hence, the radial extension 21 is axially displaced in relation to the flange 18. For example, the radial extension 21 is displaced around the axis A in relation to the protrusion 19. For example, the radial extension 21 is arranged substantially diametrically across the cylinder portion 17 in relation to the protrusion 19. For example, the arm 20 and the extension 21 extend in a common plane. In the illustrated embodiment, the locking device 13 is provided with an optional crest 22. For example, the crest 22 is arranged on the radial extension 21.

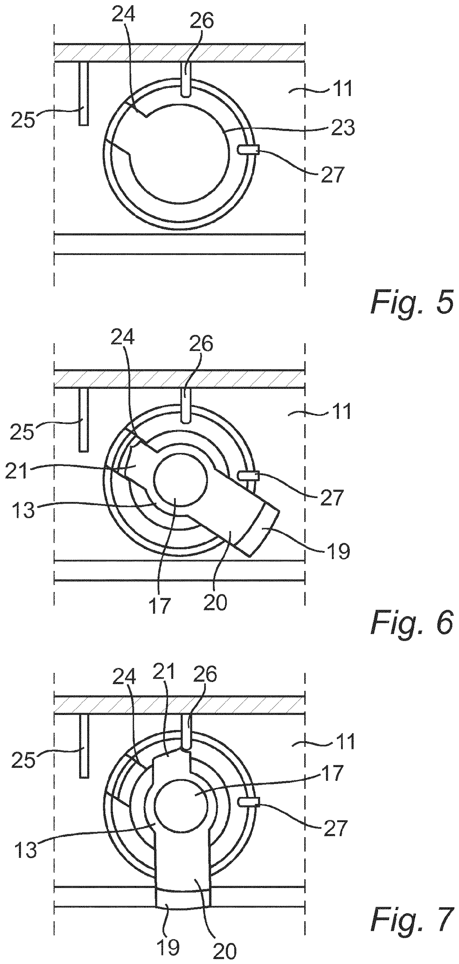

With reference to Figs. 5-12 assembly of the device 10 is illustrated according to one embodiment. In Fig. 5 a part of the first element 11 is illustrated according to one example. The first element 11 comprises a through aperture 23 and a notch 24, wherein the aperture 23 is formed with an irregularity in the form of the notch 24. For example, the aperture 23 is circular or substantially circular, wherein the notch 24 extends from an imaginary circumference of the circular aperture 23 and around a portion of the circumference to form the notch 24 in the first element 11. The aperture 23 can also be described as having a circular or substantially circular first part and a second part in the form of the notch 24 as an irregularity on the periphery of the circular part of the aperture 23. In the illustrated embodiment, the notch 24 is substantially rectangular but can be of any desired shape. In the illustrated embodiment the first element 11 is provided with an optional rib 25 and optional elevations 26, 27, which are described more in detail below.

With reference to Fig. 6 the radial extension 21 of the locking device 13 is aligned with the notch 24, so that the protrusion 19 and the cylinder portion 17 of the locking device 13 can be inserted into the aperture 23. The protrusion 19 and the arm 20 are inserted into the aperture 23. For example, the arm 20 with the protrusion 19 is inserted through the aperture 23 by tilting or inclining the locking device 13 before pushing the radial extension 21 through the notch 24. Then, the radial extension 21 is fitted over the notch while the cylinder portion 17 is fitted over the aperture 23. Then, the cylinder portion 17 is inserted into the aperture 23 while the radial extension 21 is inserted through the notch 24 until the flange 19 engages a first side, such as an exterior side, of the first element 11, so that the cylinder portion 17 is rotationally fitted in the aperture 23 and the radial extension 21 is arranged at a second side of the first element 11, such as an interior side. Hence, the aperture 23 is arranged for receiving the cylinder portion 17 of the locking device 13. Then the locking device 13 is rotated around the axis of rotation A, which is illustrated in Fig. 7, so that the radial extension 21 is rotationally displaced in relation to the notch 24 and the locking device 13 is prevented from axial displacement by means of the flange 19, the radial extension 21 and the arm 20 or another radially extending element on the second end of the cylinder portion 17.

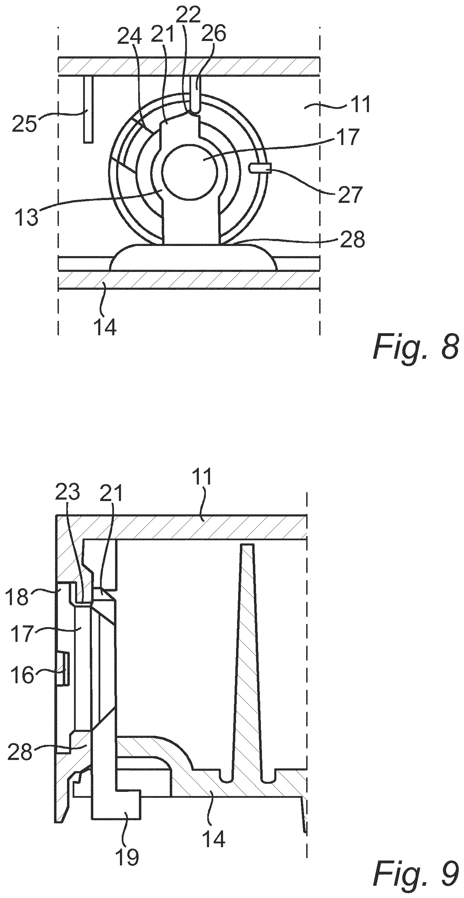

With reference to Figs. 8 and 9 the third element 14 is fixed to the first element 11. For example, the third element 14 is fixed to the first element 11 by means of conventional fastening means, such as screws, snap-locking means using mutually engaging parts and an inherent flexibility of the material, adhesives or any other suitable fastening means. The third element 14 is provided with a stop 28 to prevent the locking device 23 from rotating to a position in which the radial extension 21 is aligned with the notch 24. For example, the third element 14 prevents the locking device 13 from rotating back beyond the stop 28. For example, the stop 28 is positioned to engage a radially extending element of the locking device 13, such as the arm 20 or the radial extension 21 to prevent further rotation of the locking device 13. In the illustrated embodiment the stop 28 is arranged for engaging the arm 20 carrying the protrusion 19.

In the illustrated embodiment the locking device 13 is detachably held in place by means of the crest 22 of the locking device 13 and the elevation 26, wherein the crest 22 and elevation 26 interact to prevent the locking device 23 from unintentional rotation. For example, the stop 28 prevents the locking device 13 from rotating in a first direction, such as counter clockwise, and the crest 22 and the elevation 26 prevent the locking key 13 from rotating in an opposite second direction, such as clockwise, to form a snap-lock function by the inherent flexible properties of the material of the locking device 13 and the first element 11. For example, the crest 22 and the elevation 26 provide a tactile indication that the locking device 13 is in its locked position and, for example, that an end position has been reached.

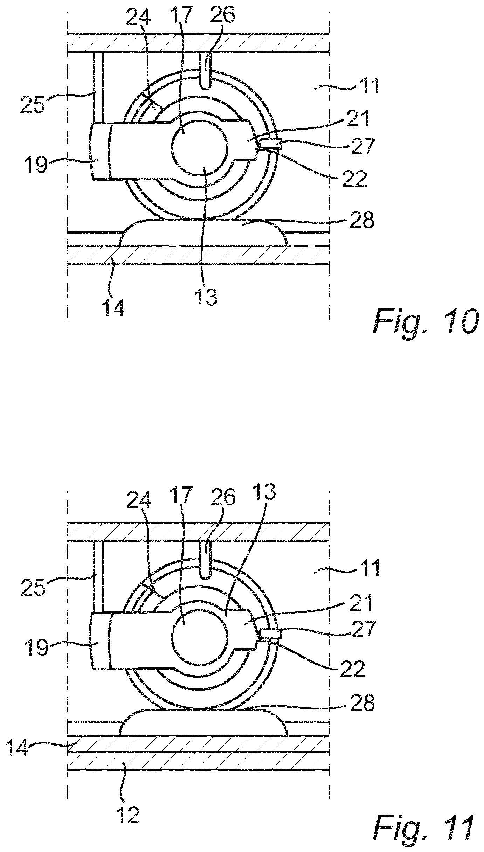

With reference to Fig. 10 the locking device 13 is rotated to an open position. In the embodiment of Fig. 10 the locking device 13 is detachably held in the open position by means of the crest 22 and the elevation 27. Further, in the illustrated embodiment the rib 25 prevents the locking device 13 from rotating beyond the open position, such as in the second direction. Simultaneously, the crest 22 and elevation 27 prevent the locking device 13 from rotating in the first direction to form a snap-lock function. For example, the crest 22 and the elevation 27 provide a tactile indication that the locking device 13 is in its open position and, for example, that an end position has been reached. Hence, the elevations 26, 27 are rotationally displaced around the aperture 23 and around the axis A. For example, the elevations 26, 27 are offset 90 degrees around the axis A in relation to each other.

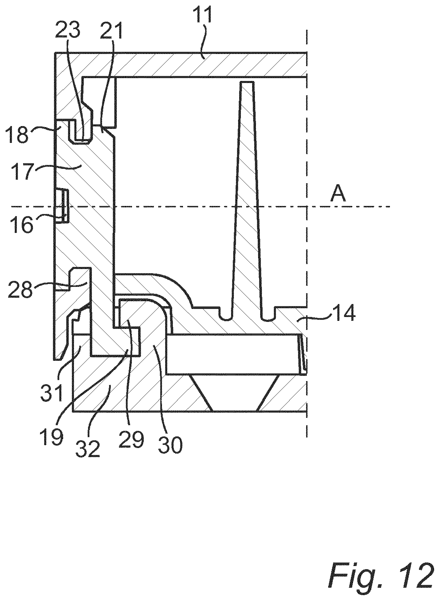

With reference to Fig. 11 the first element 11, the third element 14 and the locking device 13 is fitted to the second element 12 when the locking device 13 is in its open position or at least in an unlocked position. Then, the locking device 13 is rotated from its open position to its locked position, which is illustrated in Fig. 12. The second element 12 is provided with a projection 29 for interaction with the protrusion 19 of the locking device 13. Hence, when the locking device 13 is rotated around the axis of rotation A, the protrusion 19 is rotated into locking engagement with the projection 29. The projection 29 extends substantially in the same direction as the protrusion 19, such as axially, and is displaced radially in relation to the protrusion 19, so that the protrusion 19 can be positioned in contact with the projection 29 to prevent radial displacement of the first element 11 in relation to the second element 12. Hence, the protrusion 19 and the projection 29 are formed with mutually engaging surfaces resulting from the axially extending protrusion 19 and projection 29. In the embodiment of Fig. 12 the projection 29 is arranged on a radially extending portion 30, wherein the radially extending portion 30 and the projection 29 together from an L-shaped structure or a hook structure. The protrusion 19 and the arm 20 also form a corresponding L-shaped structure or hook structure for locking engagement with the hook structure formed by the projection 29 and the radially extending portion 30.

In the embodiment of Fig. 12 the second element 12 is formed with a radially extending wall 31 for engaging the arm 20 to prevent axial displacement of the first element 11 in relation to the second element 12 when the locking device 13 is in the locked position. Hence, the radially extending portion 30 and the radially extending wall 31 engage opposite radially extending sides of the protrusion 19. The radially extending wall 31 is connected to the radially extending portion 30 by an axially extending part 32 of the second element 12. For example, the wall 31, the radially extending portion 30, the axially extending part 32 and the projection 29 form a groove for receiving the protrusion 19 and enclose it.

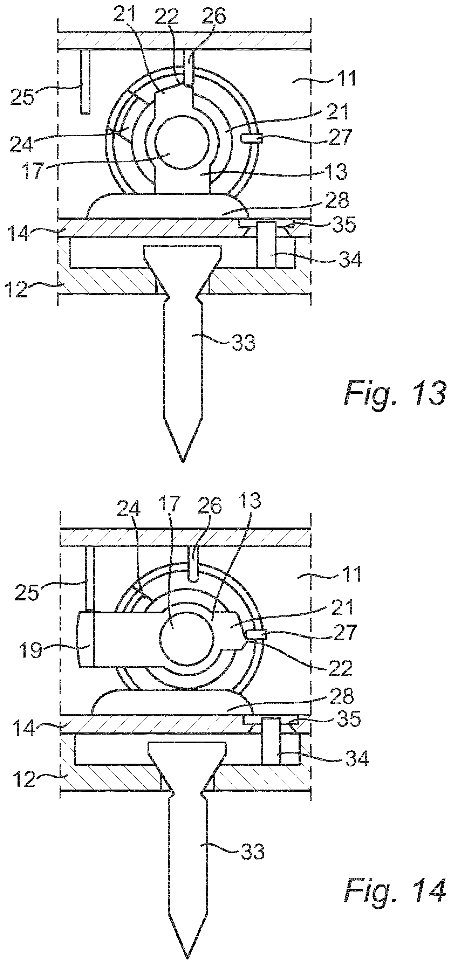

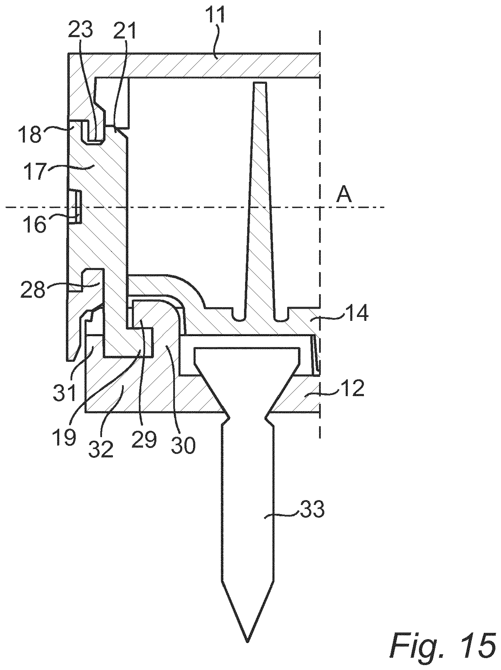

With reference to Figs. 13-15 the device is illustrated according to one embodiment, wherein the locking device 13 is in its locked position in Figs. 13 and 15 and is in its open position in Fig. 14. In the embodiment of Figs. 13-15, the second element 12 is fastened to a structure, such as a wall, ceiling, door frame, window frame or any other suitable structure, by means of conventional fastening means 33, such as screws. For example, the first element 11 or the third element 14 interacts with the second element 12 by means of one or more fixed pins and openings or a fixed hook and an opening in a conventional manner to guide the assembly of the first element 11, the third element 14 and the locking device 13 to the second element 12 so as to facilitate mounting thereof, which is not illustrated in the drawings. Alternatively, the second element 12 is provided with a recess for receiving a protrusion in the third element 14 or the first element 11 to guide the assembly of the first element 11, the third element 14 and the locking device 13 to the second element 12, which is not illustrated in the drawings.

In the embodiment of Figs. 13 and 14 the second element 12 is formed with one or more pins 34, wherein the first element 11 and the third element 14 are formed with a corresponding hole 35 for receiving the pin 34. For example, the pin 34 and hole 35 form a tamper detection setting off an alarm if the assembly of the first element 11, the third element 14 and the locking device 13 is removed from the second element 12. The pin 34 is, for example, connected to a switch, such as a switch on a printed circuit board, wherein the alarm is set off when the pin 34 is removed from the hole 35. Alternatively, the pin 34 and the hole 35 are arranged to guide the first element 11 to the second element 12 and possibly also hold the first element 11 against the second element 12 temporarily while the locking device 13 is rotated to its locking position for fastening the first element 11 to the second element 12.

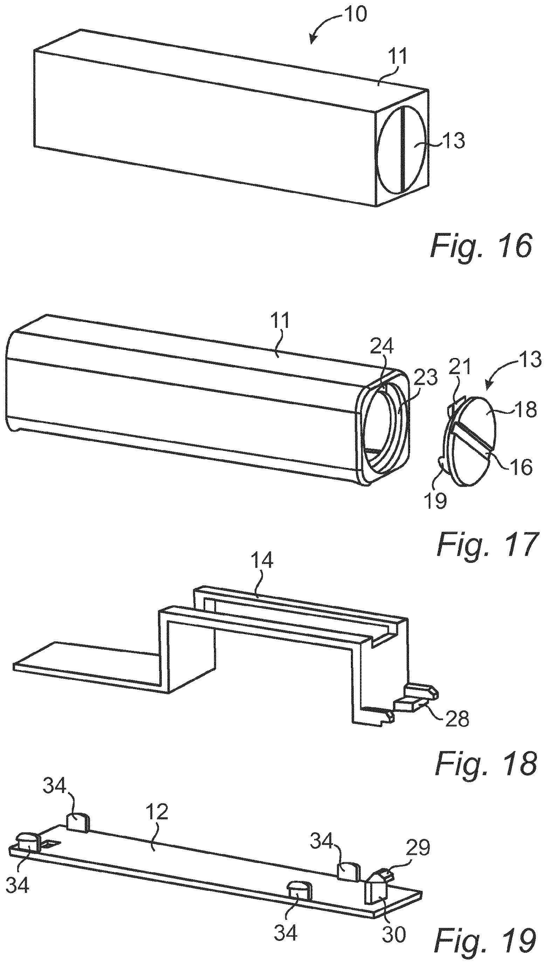

With reference to Fig. 16 and Figs. 17-19 other embodiments are disclosed. In the embodiments of Fig. 16 and Figs. 17-19 the device 10 is, for example, a casing and bracket for an intrusion alarm detector, such as a door detector or a window detector or similar. Alternatively, the device 10 is a box-shaped structure, such as a casing or a casing and a bracket for mounting on a support structure, such as a wall, ceiling, door, door frame, window frame or any other suitable supporting structure. According to the embodiments of the device 10 of Figs. 16-19 the device 10 comprises the first element 11, the second element 12, the locking device 13 and the third element 14. The first element 11, the second element 12, the locking device 13 and the third element 14 are, for example, made entirely of plastic materials, such as moulded plastic articles. Alternatively, the device 10 comprises metal parts, such as an exterior part of the locking device 13.

The first element 11 is, for example, formed as a casing having the aperture 23 and the notch 24 for receiving the locking device 13. For example, the first element 11 comprises three interconnected walls substantially forming a U-shape, and first and second end walls, wherein the aperture 23 is arranged in one of said end walls. The locking device 13 is formed with the groove 16 for receiving a tool to rotate the locking device 13. The locking device 10 also comprises the radial extension 21 to be fitted through the notch 24. The third element 14 according to one embodiment is disclosed in Fig. 18 and the second element 12 according to one embodiment is disclosed in Fig. 19. The third element 14 is, for example, arranged as a back cover or an inner frame for mounting on or in the first element 11. The third element 14 comprises the stop 28, which is formed as an axially extending part. The second element 12 is provided with the projection 29 and the radially extending portion 30. In the embodiment of Fig. 19 the second element 22 also comprises the pins 34, for example having flanges, for interaction with corresponding holes or flanges in the first element 11 or the third element 14.

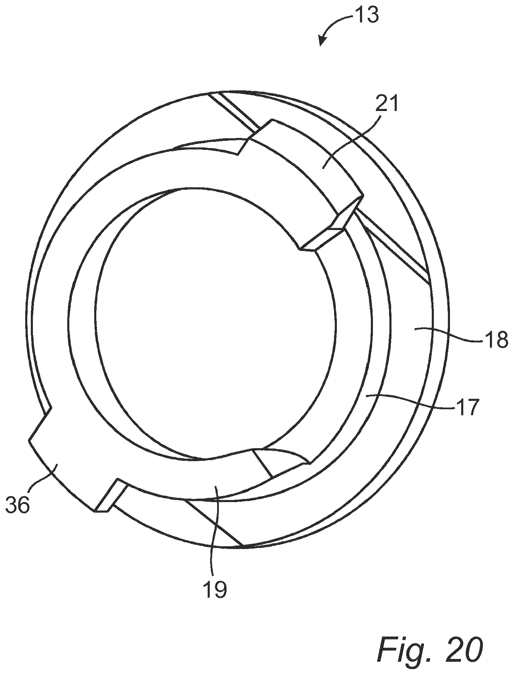

With reference to Fig. 20 the locking device of Fig. 17 is illustrated more in detail from an opposite side thereof, such as a second side or an interior side. The locking device 13 comprises the cylinder portion 17, the flange 18 and the protrusion 19. Further, the locking device 13 comprises the radial extension 21. In the embodiment of Fig. 20 the protrusion 19 extends axially from the cylinder portion 17 at a distance from the axis of rotation A, so that the protrusion 19 is displaced radially in relation to the axis of rotation. The protrusion 19 is formed as an extension of the periphery of the cylinder portion 17 around a part thereof, wherein the protrusion 19, for example, is formed as an arc-shaped rib.

In the embodiment of Fig. 20 the locking device 13 is formed with a radially extending tab 36. The tab 36 is, for example, part of the protrusion 19 or extends from the protrusion 19. The tab 36 is, for example, rotationally displaced in relation to the protrusion 19 or the part of the protrusion 19 engaging the projection 29. Optionally, the tab 36 is also rotationally displaced in relation to the radial extension 21. The tab 36 is arranged on the second end of the cylinder portion 17, wherein the tab 36 is axially displaced in relation to the flange 18. For example, the tab 36 and the extension 21 extend in a common plane.

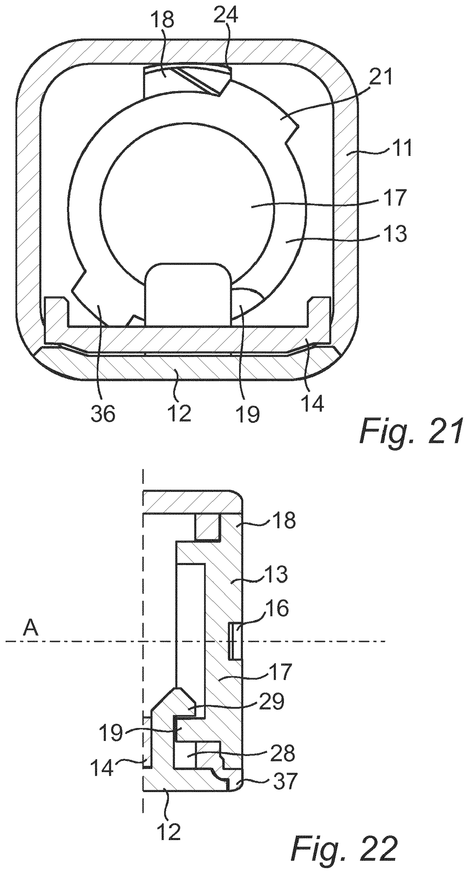

With reference to Figs. 21 and 22 the device 10 is illustrated according to one embodiment, wherein the locking device 13 is in its locked position. Similar to the embodiments of Figs. 5-15 the locking device 13 is fitted in the aperture 23 by inserting the radial extension 21 through the notch 24. For example, the tab 36 is inserted through the aperture by tilting or inclining the locking device 13 before pushing the radial extension 21 through the notch 24. The flange 18 prevents the locking device 13 from falling into the aperture 23. Hence, the flange 18 has larger diameter than the aperture 24 or comprises parts extending radially beyond the circumference of the aperture 23. The cylinder portion 17 is fitted in the aperture 23. Then, the locking device 13 is rotated around the axis A of rotation until the radial extension 21 is rotationally displaced and misaligned in relation to the notch 24. Then, the first element is fastened to the third element 14, such as by conventional fastening means, so that the stop 28 prevents the locking device 13 from rotating to a position in which the radial extension 21 is aligned with the notch 24. The tab 36 is arranged for interaction with the stop 28, wherein the tab 36 engages the stop 28 in a predetermined rotational position of the locking device 13 to prevent the locking device 13 from leaving the aperture 23. For example, the tab 36 is arranged diametrically in relation to the radial extension 21, wherein the stop 28 is arranged substantially diametrically in relation to the notch 24.

The protrusion 19 is arranged for locking engagement with the projection 29 by rotation of the locking device 13, wherein displacement of the first element 11 in relation to the second element 12 is prevented. When the locking device 13 is rotated, the protrusion 19 engages the projection 29. The radially extending portion 30 supporting the projection 29 extends axially, so that the projection 29 is positioned between the protrusion 19 and the axis A of rotation. For example, the engaging surfaces of the protrusion 19 and the projection 29 are arc-shaped for locking the first element 11 to the second element 12 efficiently. For example, the engaging surfaces of the protrusion 19 and the projection 29 are arc-shaped around the axis A. For example, the engaging surfaces of the protrusion 19 and the projection 29 are arranged for locking in the radial direction. Axial displacement of the first element 11 in relation to the second element 12 is, for example, prevented by means of pins and openings or any other suitable parts of the first and second elements 11, 12. Alternatively, as disclosed in Fig. 22, the first element 11 is prevented from axial displacement in relation to the second element 12 by means of a radially extending part 37 of the third element 14 enclosing at least a part of the second portion 12 or enclosing a peripheral part of the second element 12. Alternatively, the first element 11 comprises a corresponding radially extending part for interaction with the second element 12 to prevent axial displacement between them when the locking device 13 is in its locked position.

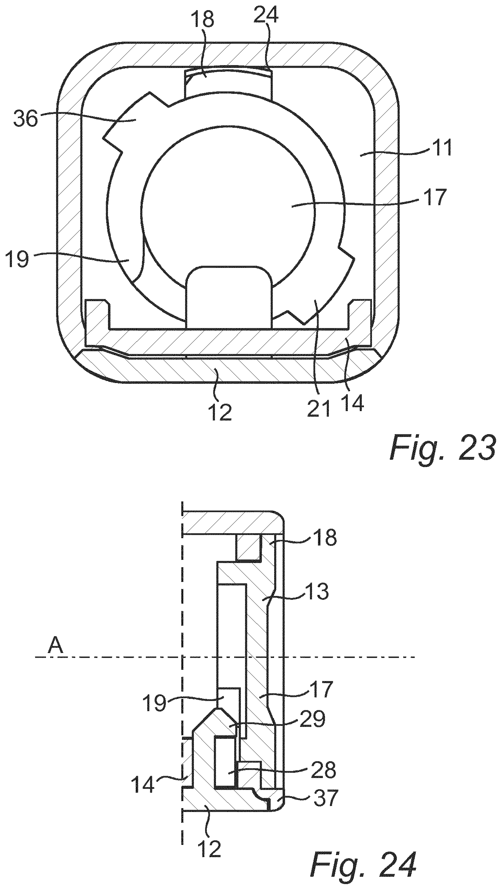

With reference to Figs. 23 and 24 the device 10 is illustrated, wherein the locking device 13 is in its open position. The protrusion 19 of the locking device 13 is disengaged from the projection 29 by rotating the locking device 13 around the axis A of rotation in one direction, such as clockwise. For example, the rotational movement in said direction is limited, such as by means of the radial extension 21. For example, the stop 28 is arranged so as to engage the radial extension 21 and prevent the locking device 13 from further rotation. Hence, according to one embodiment the rotational movement of the locking device 13 is limited in a first direction by the tab 36 and in a second direction by the radial extension 21, which engages opposite sides of the stop 28 in a closed and open position, respectively.

## Claims

1. A device (10) comprising a casing or casing front cover (11), a bracket (12), a back cover or inner frame (14) and a locking device (13) for fastening the casing or casing front cover (11) to the bracket (12), wherein the back cover or inner frame (14) is fixed to the casing or casing front cover (11), wherein the locking device (13) is connected to the casing or casing front cover (11) and is rotatable around an axis (A) of rotation from an open position to a locked position to engage the bracket (12), wherein the locking device (13) comprises a cylinder portion (17) extending along the axis (A) of rotation and having a first end and a second end, and an axially extending protrusion (19) connected to the second end of the cylinder portion (17), wherein the casing or casing front cover (11) is provided with a through aperture (23) for receiving the cylinder portion (17) of the locking device (13), and wherein the bracket (12) is provided with a projection (29) for interaction with the protrusion (19) of the locking device (13), ***cha***
***racterised*** in that
the locking device (13) comprises a flange (18) extending radially from the first end of the cylinder portion (17), wherein the flange (18) of the locking device (13) engages a first side of the casing or casing front cover (11) at the aperture (23),
the locking device (13) comprises a radial extension (21) extending around a part of the circumference of the cylinder portion (17),
the aperture (23) is formed with a notch (24) for receiving the radial extension (21), and
the back cover or inner frame (14) is provided with a stop (28) to prevent the locking device (13) from rotating to a position in which the extension (21) is aligned with the notch (24).

2. A device according to claim 1, wherein the projection (29) of the bracket (12) extends axially and is arranged between the protrusion (19) and the axis (A) to engage the protrusion (19) when the locking device (13) is in its locked position.

3. A device according to claim 1 or 2, wherein the locking device (13) comprises a radially extending arm (20) provided with the protrusion (19).

4. A device according to any of the preceding claims, wherein the protrusion (19) and the extension (21) are positioned substantially diametrically on the cylinder portion (17).

5. A device according to any of the preceding claims, wherein the aperture (23) is circular and the casing or casing front cover (11) is provided with the notch (24) on the periphery of the aperture (23).

6. A device according to any of the preceding claims, wherein the stop (28) is arranged to engage the protrusion (19) in the locked position of the locking device (13) and prevent the locking device (13) from further rotation in the same direction.

7. A device according to claim 6, wherein the protrusion (19) comprises a tab (36) for engaging the stop (28) in the locked position of the locking device (13).

8. A device according to any of the preceding claims, wherein the casing or casing front cover (11) is provided with a rib (25) arranged to engage the protrusion (19) in the open position of the locking device (13) to prevent the locking device (13) from further rotation in the same direction.

9. A device according to any of the preceding claims, wherein the casing or casing front cover (11) is provided with one or more elevations (26, 27), and the locking device (13) is provided with a crest (22) for interaction with the one or more elevations (26, 27) through inherent flexible properties thereof to detachably fasten the locking device (13) in the locked position and/or open position.

10. A device according to any of the preceding claims, wherein the casing or casing front cover (11) and the locking device (13) are provided with a bump and an indentation, respectively, for mutual interaction through inherent flexible properties thereof to detachably fasten the locking device in the open position and/or locked position.

11. An intrusion alarm component comprising a device according to any of the preceding claims, and a detector and/or a processor and/or wireless communication means.

12. A method for assembling a device (10) comprising a casing or casing front cover (11), a bracket (12), a back cover or inner frame (14) and a locking device (13) for fastening the casing or casing front cover (11) to the bracket (12), comprising the steps of
a) inserting a locking device (13) into a through aperture (23) in the casing or casing front cover (11),
b) aligning a radial extension (21) of the locking device (13) with a notch (24) in the casing or casing front cover (11) adjacent the aperture (23),
c) pushing the extension (21) through the notch (24), and an axially extending cylinder portion (17) of the locking device (13) into the aperture (23) until a radially extending flange (18) of the locking device (13) engages a first side of the casing or casing front cover (11) around the aperture (23),
d) rotating the locking device (13) so that the extension (21) is displaced in relation to the notch (24),
e) fixing a back cover or inner frame (14) to the casing or casing front cover (11), the back cover or inner frame (14) preventing the locking device (13) from rotating in at least one direction to a position in which the extension (21) is aligned with the notch (24),
f) bringing the bracket (12) into engagement with the casing or casing front cover (11), and
g) rotating the locking device (13) and thereby bring an axially extending protrusion (19) of the locking device (13) into locking engagement with a projection (29) of the bracket (12).

## Patentansprüche

1. Vorrichtung (10) mit einem Gehäuse oder einer Gehäusefrontabdeckung (11), einer Halterung (12), einer Rückabdeckung oder einem Innenrahmen (14) und einer Verriegelungsvorrichtung (13) zum Befestigen des Gehäuses oder der Gehäusefrontabdeckung (11) an der Halterung (12), wobei die Rückabdeckung oder der Innenrahmen (14) an dem Gehäuse oder der Gehäusefrontabdeckung (11) befestigt ist, wobei die Verriegelungsvorrichtung (13) mit dem Gehäuse oder der Gehäusefrontabdeckung (11) verbunden ist und um eine Drehachse (A) von einer offenen Position in eine verriegelte Position drehbar ist, um in die Halterung (12) einzugreifen, wobei die Verriegelungsvorrichtung (13) einen Zylinderteil (17), der sich entlang der Drehachse (A) erstreckt und ein erstes Ende und ein zweites Ende aufweist, und einen axial erstreckenden Vorsprung (19), der mit dem zweiten Ende des Zylinderteils (17) verbunden ist, umfasst, wobei das Gehäuse oder die Gehäusefrontabdeckung (11) über eine Durchgangsöffnung (23) zur Aufnahme des Zylinderteils (17) der Verriegelungsvorrichtung (13) verfügt, und wobei die Halterung (12) über eine Ausbildung (29) zur Interaktion mit dem Vorsprung (19) der Verriegelungsvorrichtung (13) verfügt,
**dadurch gekennzeichnet, dass**
die Verriegelungsvorrichtung (13) einen Flansch (18) umfasst, der sich radial von dem ersten Ende des Zylinderteils (17) erstreckt, wobei der Flansch (18) der Verriegelungsvorrichtung (13) in eine erste Seite des Gehäuses oder der Gehäusefrontabdeckung (11) an der Öffnung (23) eingreift,
die Verriegelungsvorrichtung (13) eine radiale Erstreckung (21) umfasst, die sich um einen Teil des Umfangs des Zylinderteils (17) erstreckt,
die Öffnung (23) mit einer Nut (24) zur Aufnahme der radialen Erstreckung (21) ausgebildet ist, und
die Rückabdeckung oder der Innenrahmen (14) über einen Anschlag (28) verfügt, um die Verriegelungsvorrichtung (13) an einer Drehung in eine Position zu hindern, in der die Erstreckung (21) mit der Nut (24) ausgerichtet ist.

2. Vorrichtung gemäß Anspruch 1, wobei sich die Ausbildung (29) der Halterung (12) axial erstreckt und zwischen dem Vorsprung (19) und der Achse (A) angeordnet ist, um in den Vorsprung (19) einzugreifen, wenn sich die Verriegelungsvorrichtung (13) in ihrer Verriegelungsposition befindet.

3. Vorrichtung gemäß Anspruch 1 oder 2, wobei die Verriegelungsvorrichtung (13) einen sich radial erstreckenden Arm (20) umfasst, der über den Vorsprung (19) verfügt.

4. Vorrichtung nach einem der vorhergehenden Ansprüche, wobei der Vorsprung (19) und die Erstreckung (21) im Wesentlichen diametral auf dem Zylinderteil (17) angeordnet sind.

5. Vorrichtung gemäß einem der vorhergehenden Ansprüche, wobei die Öffnung (23) kreisförmig ist und das Gehäuse oder die Gehäusefrontabdeckung (11) über die Nut (24) an dem Umfang der Öffnung (23) verfügt.

6. Vorrichtung gemäß einem der vorhergehenden Ansprüche, wobei der Anschlag (28) angeordnet ist, um in den Vorsprung (19) in der verriegelten Position der Verriegelungsvorrichtung (13) einzugreifen und zu verhindern, dass sich die Verriegelungsvorrichtung (13) weiter in die gleiche Richtung dreht.

7. Vorrichtung gemäß Anspruch 6, wobei der Vorsprung (19) eine Lasche (36) zum Eingriff mit dem Anschlag (28) in der Verriegelungsposition der Verriegelungsvorrichtung (13) umfasst.

8. Vorrichtung gemäß einem der vorhergehenden Ansprüche, wobei das Gehäuse oder die Gehäusefrontabdeckung (11) über einer Rippe (25) verfügt, die zum Eingreifen in den Vorsprung (19) in der geöffneten Position der Verriegelungsvorrichtung (13) angeordnet ist, um die Verriegelungsvorrichtung (13) vor einer weiteren Drehung in der gleichen Richtung zu hindern.

9. Vorrichtung gemäß einem der vorhergehenden Ansprüche, wobei das Gehäuse oder die Gehäusefrontabdeckung (11) über eine oder mehrere Erhöhungen (26, 27) verfügt und die Verriegelungsvorrichtung (13) über einen Kamm (22) zur Interaktion mit der einen oder mehreren Erhöhungen (26, 27) durch deren inhärente flexible Eigenschaften verfügt, um die Verriegelungsvorrichtung (13) in der verriegelten und/oder geöffneten Position lösbar zu befestigen.

10. Vorrichtung gemäß einem der vorhergehenden Ansprüche, wobei das Gehäuse oder die Gehäusefrontabdeckung (11) und die Verriegelungsvorrichtung (13) entsprechend über eine Erhebung und eine Einbuchtung zur gegenseitigen Interaktion durch inhärente flexible Eigenschaften davon verfügen, um die Verriegelungsvorrichtung in der offenen und/oder verriegelten Position lösbar zu befestigen.

11. Einbruchmeldekomponente, die eine Vorrichtung gemäß einem der vorhergehenden Ansprüche und einen Detektor und/oder einen Prozessor und/oder drahtlose Kommunikationsmittel umfasst.

12. Verfahren zum Montieren einer Vorrichtung (10), die ein Gehäuse oder eine Gehäusefrontabdeckung (11), eine Halterung (12), eine Rückabdeckung oder einen Innenrahmen (14) und eine Verriegelungsvorrichtung (13) zur Befestigung des Gehäuses oder der Gehäusefrontabdeckung (11) an der Halterung (12) umfasst, die folgenden Schritte umfassend
a) Einsetzen einer Verriegelungsvorrichtung (13) in eine Durchgangsöffnung (23) in dem Gehäuse oder der Gehäusefrontabdeckung (11),
b) Ausrichten einer radialen Erstreckung (21) der Verriegelungsvorrichtung (13) mit einer Nut (24) in dem Gehäuse oder der Gehäusefrontabdeckung (11) angrenzend an die Öffnung (23),
c) Schieben der Erstreckung (21) durch die Nut (24) und einen sich axial erstreckenden Zylinderteil (17) der Verriegelungsvorrichtung (13) in die Öffnung (23), bis ein sich radial erstreckender Flansch (18) der Verriegelungsvorrichtung (13) in eine erste Seite des Gehäuses oder der Gehäusefrontabdeckung (11) um die Öffnung (23) eingreift,
d) Drehen der Verriegelungsvorrichtung (13), so dass die Erstreckung in Bezug auf die Nut (24) versetzt wird,
e) Fixieren einer Rückabdeckung oder eines Innenrahmens (14) an dem Gehäuse oder der Gehäusefrontabdeckung (11), wobei die Rückabdeckung oder der Innenrahmen (14) verhindert, dass sich die Verriegelungsvorrichtung (13) in mindestens eine Richtung in eine Position dreht, in der die Erstreckung (21) mit der Nut (24) ausgerichtet ist,
f) in Eingriff bringen der Halterung (12) mit dem Gehäuse oder der Gehäusefrontabdeckung (11), und
g) Drehen der Verriegelungsvorrichtung (13) und dadurch in Verriegelungseingriff bringen eines axial verlaufenden Vorsprungs (19) der Verriegelungsvorrichtung (13) mit einer Ausbildung (29) der Halterung (12).

## Revendications

1. Dispositif (10) comprenant un boîtier ou une partie de recouvrement avant de boîtier (11), une partie de support (12), une partie de recouvrement arrière ou structure interne (14) et un dispositif de verrouillage (13) pour lier le boîtier ou la partie de recouvrement avant de boîtier (11) à la partie de support (12), dans lequel la partie de recouvrement arrière ou structure interne (14) est fixée au boîtier ou à la partie de recouvrement avant de boîtier (11), dans lequel le dispositif de verrouillage (13) est connecté au boîtier ou à la partie de recouvrement avant de boîtier (11) et peut tourner autour d'un axe (A) de rotation depuis une position ouverte jusqu'à une position verrouillée de manière à ce qu'il engage la partie de support (12), dans lequel le dispositif de verrouillage (13) comprend une section de cylindre (17) qui s'étend suivant l'axe (A) de rotation et qui comporte une première extrémité et une seconde extrémité, et une protubérance s'étendant axialement (19) qui est connectée à la seconde extrémité de la section de cylindre (17), dans lequel le boîtier ou la partie de recouvrement avant de boîtier (11) est muni(e) d'une ouverture traversante (23) pour recevoir la section de cylindre (17) du dispositif de verrouillage (13), et dans lequel la partie de support (12) est munie d'une protubérance (29) dont l'objet est d'interagir avec la protubérance (19) du dispositif de verrouillage (13) ;
**caractérisé en ce que** :
le dispositif de verrouillage (13) comprend une bride (18) qui s'étend radialement depuis la première extrémité de la section de cylindre (17), dans lequel la bride (18) du dispositif de verrouillage (13) engage un premier côté du boîtier ou de la partie de recouvrement avant de boîtier (11) au niveau de l'ouverture (23) ;
le dispositif de verrouillage (13) comprend une extension radiale (21) qui s'étend sur une partie de la circonférence de la section de cylindre (17) ;
l'ouverture (23) est formée de manière à ce qu'elle soit munie d'une encoche (24) pour recevoir l'extension radiale (21) ; et
la partie de recouvrement arrière ou structure interne (14) est munie d'une butée d'arrêt (28) dont l'objet est d'empêcher que le dispositif de verrouillage (13) ne tourne jusqu'à une position dans laquelle l'extension (21) est alignée avec l'encoche (24).

2. Dispositif selon la revendication 1, dans lequel la protubérance (29) de la partie de support (12) s'étend axialement et est agencée entre la protubérance (19) et l'axe (A) de manière à ce qu'elle engage la protubérance (19) lorsque le dispositif de verrouillage (13) est dans sa position verrouillée.

3. Dispositif selon la revendication 1 ou 2, dans lequel le dispositif de verrouillage (13) comprend un bras s'étendant radialement (20) qui est muni de la protubérance (19).

4. Dispositif selon l'une quelconque des revendications précédentes, dans lequel la protubérance (19) et l'extension (21) sont positionnées sensiblement diamétralement sur la section de cylindre (17).

5. Dispositif selon l'une quelconque des revendications précédentes, dans lequel l'ouverture (23) est circulaire et le boîtier ou la partie de recouvrement avant de boîtier (11) est muni(e) de l'encoche (24) sur la périphérie de l'ouverture (23).

6. Dispositif selon l'une quelconque des revendications précédentes, dans lequel la butée d'arrêt (28) est agencée de manière à ce qu'elle engage la protubérance (19) dans la position verrouillée du dispositif de verrouillage (13) et de manière à ce qu'elle empêche que le dispositif de verrouillage (13) ne réalise une rotation supplémentaire dans le même sens.

7. Dispositif selon la revendication 6, dans lequel la protubérance (19) comprend une languette (36) dont l'objet est d'engager la butée d'arrêt (28) dans la position verrouillée du dispositif de verrouillage (13).

8. Dispositif selon l'une quelconque des revendications précédentes, dans lequel le boîtier ou la partie de recouvrement avant de boîtier (11) est muni(e) d'une nervure (25) qui est agencée de manière à ce qu'elle engage la protubérance (19) dans la position ouverte du dispositif de verrouillage (13) de manière à empêcher que le dispositif de verrouillage (13) ne réalise une rotation supplémentaire dans le même sens.

9. Dispositif selon l'une quelconque des revendications précédentes, dans lequel le boîtier ou la partie de recouvrement avant de boîtier (11) est muni(e) d'un ou de plusieurs élément(s) en surélévation (26, 27), et le dispositif de verrouillage (13) est muni d'une partie en forme de crête (22) dont l'objet est d'interagir avec les un ou plusieurs éléments en surélévation (26, 27) grâce à leurs propriétés flexibles inhérentes de manière à lier de façon réversible le dispositif de verrouillage (13) dans la position verrouillée et/ou la position ouverte.

10. Dispositif selon l'une quelconque des revendications précédentes, dans lequel le boîtier ou la partie de recouvrement avant de boîtier (11) et le dispositif de verrouillage (13) sont respectivement munis d'un bossage et d'une indentation dont l'objet est de réaliser une interaction mutuelle grâce à leurs propriétés flexibles inhérentes de manière à lier de façon réversible le dispositif de verrouillage dans la position ouverte et/ou la position verrouillée.

11. Composant d'alarme d'intrusion comprenant un dispositif selon l'une quelconque des revendications précédentes, et un détecteur et/ou un processeur et/ou un moyen de communication sans fil.

12. Procédé pour assembler un dispositif (10) qui comprend un boîtier ou une partie de recouvrement avant de boîtier (11), une partie de support (12), une partie de recouvrement arrière ou structure interne (14) et un dispositif de verrouillage (13) pour lier le boîtier ou la partie de recouvrement avant de boîtier (11) à la partie de support (12), comprenant les étapes constituées par :
a) l'insertion d'un dispositif de verrouillage (13) à l'intérieur d'une ouverture traversante (23) qui est ménagée dans le boîtier ou la partie de recouvrement avant de boîtier (11) ;
b) l'alignement d'une extension radiale (21) du dispositif de verrouillage (13) avec une encoche (24) qui est ménagée dans le boîtier ou la partie de recouvrement avant de boîtier (11) de telle sorte qu'elle soit adjacente à l'ouverture (23) ;
c) l'exercice d'une poussée sur l'extension (21) de manière à l'amener au travers de l'encoche (24), et sur une section de cylindre s'étendant axialement (17) du dispositif de verrouillage (13) de manière à l'amener à l'intérieur de l'ouverture (23) jusqu'à ce qu'une bride s'étendant radialement (18) du dispositif de verrouillage (13) engage un premier côté du boîtier ou de la partie de recouvrement avant de boîtier (11) au niveau du pourtour de l'ouverture (23) ;
d) la rotation du dispositif de verrouillage (13) de telle sorte que l'extension (21) soit déplacée en relation avec l'encoche (24) ;
e) la fixation d'une partie de recouvrement arrière ou structure interne (14) sur le boîtier ou la partie de recouvrement avant de boîtier (11), la partie de recouvrement arrière ou structure interne (14) empêchant que le dispositif de verrouillage (13) ne tourne dans au moins un sens jusqu'à une position dans laquelle l'extension (21) est alignée avec l'encoche (24) ;
f) l'amenée de la partie de support (12) en engagement avec le boîtier ou la partie de recouvrement avant de boîtier (11) ; et
g) la rotation du dispositif de verrouillage (13) et de ce fait, l'amenée d'une protubérance s'étendant axialement (19) du dispositif de verrouillage (13) en engagement de verrouillage avec une protubérance (29) de la partie de support (12).
